(19) Europäisches Patentamt
European Patent Office
Office européen des brevets

(11) **EP 2 075 484 A1**

(12) **EUROPEAN PATENT APPLICATION**

(43) Date of publication:
**01.07.2009 Bulletin 2009/27**

(51) Int Cl.:
***F16F 15/02*** *(2006.01)* ***F16F 15/03*** *(2006.01)*

(21) Application number: **07124174.9**

(22) Date of filing: **31.12.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK**

(71) Applicant: **Nederlandse Organisatie voor toegepast-natuurwetenschappelijk onderzoek TNO**
**2628 VK Delft (NL)**

(72) Inventors:
• **Kastelijn, Aukje**
**2628 VK Delft (NL)**

• **van den Dool, Teunis Cornelis**
**2623 HH Delft (NL)**
• **Fraanje, Rufus**
**2628 VK Delft (NL)**
• **Zuljar, Robert**
**2628 VK Delft (NL)**

(74) Representative: **Hatzmann, Martin**
**Vereenigde**
**Johan de Wittlaan 7**
**2517 JR Den Haag (NL)**

(54) **An active vibration isolation system having an inertial reference mass**

(57) An active vibration isolation system comprises a platform (1), an inertial reference mass (4), a support unit (10) for supporting the reference mass (4) without mechanical contact, a first sensor (6) for supplying a signal that is representative for the distance between the reference mass (4) and the platform (1), an actuator (3) for displacing the platform (1) with respect to a bearing body (8), a second sensor (7) for supplying a signal that is representative for the distance between the platform (1) and the bearing body (8), and a control unit (11) for controlling the actuator (3). In accordance with the invention, the support unit (10) is supported by the platform (1).

Fig. 2

**Description**

The present invention relates to an active vibration isolation system with an inertial reference mass. More in particular, the present invention relates to an active vibration isolation system comprising a platform, an inertial reference mass, a support unit for supporting the reference mass without mechanical contact, a first sensor for supplying a signal that is representative for the distance between the reference mass and the platform, an actuator for displacing the platform with respect to a bearing body, a second sensor for supplying a signal that is representative for the distance between the platform and the bearing body, and a control unit for controlling the actuator.

A simple method to isolate a platform and the load on the platform from earth vibrations is by using mechanical springs, elastomers or magnetic bearings. However, at frequencies below the resonance frequency of the system consisting of the platform and the bearing, no isolation can be obtained with such a passive vibration isolation. The resonance frequency (f) is determined by the mass (m) of the platform and the stiffness (k) and the damping ratio (ζ) of the bearing:

$$f = (2\pi)^{-1}\sqrt{(1 - \zeta^2)k/m}.$$

For increasing frequencies above the resonance frequency, the amplitude of the vibration of the platform will be lowered by a factor of 100 for each decade. To obtain a reduction from a 10 micrometer amplitude of the earth vibration to a 10 nanometre vibration amplitude of the platform at 1 Hz, the resonance frequency should be 0.032 Hz to obtain this reduction with a factor of 1000. In general, bearings have a stiffness that is no smaller than k = 1000 N/m. As a consequence, the mass of the platform must be at least 25,000 kg. Platforms with such a large mass are undesirable because of the special constructions that are needed to bear such a platform, and usually have much higher stiffness than k = 1000 N/m. In practice, the resonance frequency of passive systems is not lower than 2 Hz, which means that a reduction of the vibration amplitude by a factor of 1000 and more is obtained only at frequencies higher than 63 Hz. In principle bearings with resonance frequencies below 2 Hz may be possible, e.g. using configurations with several permanent magnets to compensate for the gravity force. In addition a Lorentz type voice-coil actuator may be used, e.g. to actively stabilize the system. However, platforms suspended at low resonance frequencies are also more sensitive (compliant) to disturbance forces other than those from ground vibrations, e.g. due to dynamical processes supported by the platform.

Active control on the basis of a measurement of the vibration allows a better isolation from undesired vibrations without increasing the compliance as in (passive or active) isolation techniques that only adjust the stiffness coupling between the source, e.g. the floor, of the vibration and the platform. The principle of this active vibration control is well described in literature, see e.g. P.R. Saulson, "Vibration isolation for broadband gravitational wave antennas", Rev. Sci. Instrum. 55(8), August 1984, pp.1315-1320 and P.G. Nelson, "An active vibration isolation system for inertial reference and precision measurement", Rev. Sci. Instrum. 62 (9), September 1991, pp.2069-2075. A sensor set-up capable of detecting the undesired vibration can be placed either on the source of the vibration or on the platform that has to be isolated from earth vibrations or other mechanical disturbances. The platform is supported by springs or other bearings and it can be driven by an actuator like a servomotor along the sensitive axis of the sensor. The electronic output of the sensor is (filtered and) fed back to the actuator that compensates for the undesired vibration. As a further improvement of vibration isolation more than one sensor can be used. International Patent Application WO 2005/024266 A1 discloses in particular the use of two sensors, one for measuring the displacement of the platform with respect to the reference mass and the second one for measuring the displacement of the platform relative to the earth or floor on which the platform is placed.

The sensor set-up capable of detecting the undesired vibration typically comprises a reference mass that is small in comparison to the mass of the platform and the actual sensor measuring the vibration for instance by optical or electrical means. The reference mass is supported by a spring that has sufficiently high stiffness to compensate for the gravitational force on the mass. To obtain a resonance frequency of 0.1 Hz for a typical reference mass of 0.1 kg, the stiffness of a mechanical spring needs to be 0.003 N/m. For such a low stiffness, gravity force would result in an elongation of the spring of more than 200 meters. Special type of springs (such as constant force springs) may be used to achieve a lower stiffness without significant elongation. However, resonance frequencies well below the 1 Hz that are compact as well are difficult to achieve using mechanical springs.

The vibration of the reference mass with respect to the platform is detected mechanically, electrically, optically or electro-magnetically. For this purpose the sensor comprises a commonly known mean for detecting acceleration, velocity or distance.

It is well known that for the feedback of the signal supplied by the displacement sensor to the actuator, common PID control can be used. Noise, parasitic effects and actuator nonlinearities, however, prevent effective vibration isolation below 0.5 Hz in practise. The best performance claimed until now seems to be a resonance frequency of 0.2 Hz in a system where the actuator and the sensor are located substantially close to each other.

Earth vibrations and other mechanical disturbances are becoming more and more a limiting factor for applications that demand an environment that is free of such disturbing vibrations. Space equipment under development on earth, demands a test environment that is similar to the working environment in space. The further decreasing dimensions as foreseen for semiconductor products like processors and memories, demand a better stability of the lithographic equipment that is used for the fabrication of these products than is available at present. Low frequency vibrations are preventing further improvement of the resolution of electron and atomic force microscopes.

It is well known that a Lorentz or voice-coil type of geometry consisting of a permanent magnet and a coil can be used for bearing and displacing a platform, However, due to the large mass of a platform, considerable amount of energy (electrical power) is needed to elevate the platform permanently. Because a significant part of the energy is transferred into heat, special precautions have to be taken to shield load on the platform from the heat generated by the bearing.

The performance of the currently available vibration isolation platforms and other platforms for the isolation of vibrations do not meet the requirements asked for in the near future. In particular for low frequencies, e.g. in the band of 0.1-10 Hz, vibrations cannot be isolated sufficiently to reduce the amplitude of the vibrations of the bodies to be isolated, to a level well below 10 nanometres.

It is therefore an object of the present invention to overcome these and other problems of the Prior Art and to provide an active vibration isolation system having improved properties. More in particular, it is an object of the present invention to provide a better vibration isolation of platforms and other equipment at low frequencies, in particular in the band of 0.1-10 Hz.

Accordingly, the present invention provides an active vibration isolation system comprising a platform, an inertial reference mass, a support unit for supporting the reference mass without mechanical contact, a first sensor for supplying a signal that is representative for the distance between the reference mass and the platform, an actuator for displacing the platform with respect to a bearing body, a second sensor for supplying a signal that is representative for the distance between the platform and the bearing body, and a control unit for controlling the actuator, which system is characterised in that the support unit is supported by the platform.

By providing a support unit which is, in turn, supported by the platform on which the load can be placed, a more direct coupling is obtained which results in an improved vibration isolation.

The present invention is in particular suited for platforms that are used to support instruments under test, e.g. instruments for space applications. However, the present invention can also be used for vibration isolation in a large variety of equipment, including but not limited to telescopes, lithographic machineries and cars.

In the system according to the present invention, the support unit preferably comprises a Lorentz type of geometry supporting the reference mass. Alternatively, the support unit may comprise electromagnetic, electro-static or magneto-static mains for supporting the reference mass.

The distance between the reference mass and the platform may be measured by optical, electrical, or electromagnetic means. Advantageously, the actuator may comprise a Lorentz type of geometry. The control unit preferably receives an absolute feed-back signal from the said first sensor.

The present invention will further be explained below with reference to exemplary embodiments illustrated in the accompanying drawings, in which:

Figure 1 schematically shows an active vibration isolation system according to the state of the art.
Figure 2 schematically shows an active vibration isolation system according to the present invention.
Figure 3 schematically shows an embodiment of a reference mass, a displacement sensor, and a support unit which may be used in the system of Fig. 2.
Figure 4 graphically shows the vibration transfer from a vibrating base to a platform without active control.
Figure 5 graphically shows the level of the vibration of the base and the level of the vibration of a platform without active control.
Figure 6 schematically shows an embodiment of a controller setup as may advantageously be used in the present invention.
Figure 7 graphically shows the transfer from the base to the platform and from the base to the reference mass in a sensor system, for the case without feedback of the sensor system to the actuator between the base and the platform.
Figure 8 graphically shows the gain between the actuator located between the base and the platform on the one hand and the output of the sensor system on the other hand, i.e., the relative distance between the reference mass and the platform.
Figure 9 graphically shows the phase corresponding to the gain depicted in Figure 8.
Figure 10 graphically shows the transfer from the base to the platform, without and with control including feedback from the sensor system.

Figure 11 shows the level of vibration of the base/ground, the uncontrolled platform, the controlled platform and the influence of other disturbance forces on the base and amplifier noise in the sensor system.

Figure 12 shows the same quantities as Figure 11 that are obtained using feedback from the relative position of the table with respect to the base to the actuator of a sensor system.

The vibration isolation system of the invention comprises an inertial reference mass. Because of the fact that this mass is very softly connected to the platform that has to be isolated (with nearly zero, positive stiffness), this mass is considered to be an absolute reference for the position of the platform. Such a nearly zero stiffness cannot be obtained by conventional means like mechanical springs, as used in Saulson (1984), Nelson (1991), and WO 2004/029475 or air bearings unless allowing for large system dimensions (above several meters). Another disadvantage is (hysteretic) damping which increases the vibration sensitivity above the resonance frequency such that the sensitivity does not roll-off with a factor proportional with the squared frequency but will roll-off linearly with the frequency.

A Lorentz type of geometry, comprising a coil and a magnet, allows a zero stiffness operation while exerting a force to compensate for gravity. Due to spatial inhomogeneity of the magnetic field, the stiffness is zero in just a single point and increases or decreases away from this point. Using feedback from the position of the inertial reference mass relative to the platform, i.e. the distance between the coil and the magnet, the stiffness can be set to a low positive value to prevent drifting and to guarantee a resonance frequencies significantly below 1 Hz. In contrast to vibration isolation systems where the whole platform is borne by such an actuator, in the system according to the invention only the low-weight reference mass is borne by the actuator. Typically the reference mass will be lower than 1 kg, preferably even below 0.1 kg.

In the system according to the invention there is no need for special bearing for the platform; the common bearings can be used for supporting the platform without influencing the high level of vibration isolation. The functioning of such a bearing might, among others, be based on pneumatic or magnetic levitation or the bearing might be constructed using an elastomeric material or a mechanical spring. The same holds for the actuator; common available servo-motors and piezo-electric motors can be used. The reason that there are no specific demands is that the stiffness of both bearing and actuator is compensated by a properly designed electronic control system. In principle also a Lorentz actuator can be used for bearing the load. However, the disadvantage is that a Lorentz actuator needs an electrical current to apply a force. In particular for heavy platforms the current will result in significant heating of the actuator and its environment. For sensitive applications, cooling will be needed to transport the heat.

In the present invention an approximately absolute position feedback is used by means of a sensor system mounted on the platform to obtain the high accuracy needed for the high level of vibration isolation at low frequencies. The sensor is mounted on the table rather than the disturbance source, because the sensitivity of the sensor's reference mass to the disturbing vibrations will be even more reduced when the vibrations of the platform are suppressed. It is important that the relative position between the reference mass and the platform, as provided by the sensor system, is fed back rather than, e.g., the relative velocity as in WO 2004/029475, or acceleration, to actively suppress the vibration of the platform. Feeding back the velocity and acceleration will provide suppression of vibrations especially at the high frequencies (above the resonance frequency coupling between the platform and the vibrating source), at the expense of less suppression in the lower frequency band. To suppress the vibrations in the lower frequency band, one may integrate the velocity or doubly integrate the acceleration (e.g., Saulson 1984). However the use of an accurate displacement sensor, as in the present invention, is highly preferred to prevent the amplification of measurement and electronic (such as 1/f) noise at low frequencies. Moreover, the sensor system already consists of a displacement sensor, as indicated above, to compensate for the variation in stiffness due to the inhomogeneous magnetic field of the Lorentz actuator.

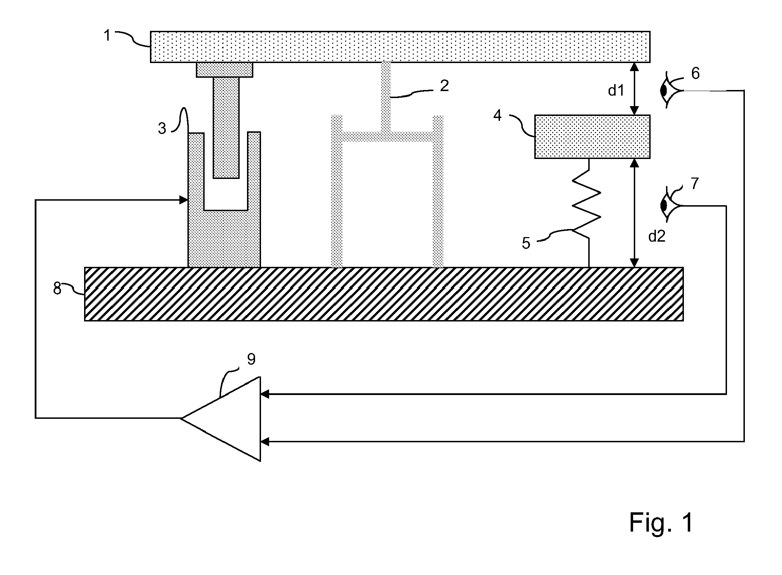

Figure 1 shows an active vibration system according to the state of the art. The platform 1 that is supported by a platform bearing 2 can be moved by an actuator 3. The reference mass 4 is supported by a reference mass bearing 5, whereas a first sensor 6 provides a signal that is representative for the distance d1 between the platform 1 and the reference mass 4 and a second sensor 7 provides a signal that is representative for the distance d2 between the reference mass 4 and the floor 8. The controller 9 is provided with the output signal of the first sensor 6 and the output signal of the second sensor 7 and the controller itself provides the actuator 3 with an input signal to move the platform 1. It will be understood that the platform 1 is suitable for accommodating a load, for example a precision instrument.

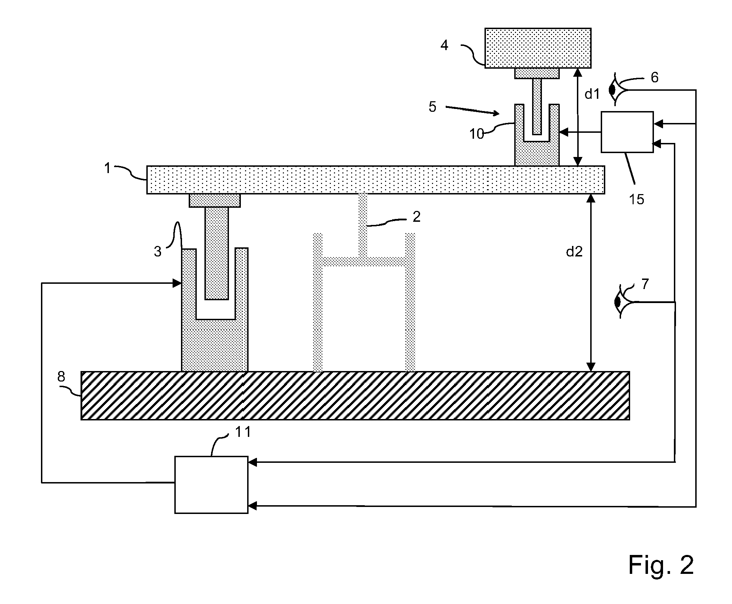

Figure 2 shows schematically an embodiment of the system according to the invention. The embodiment shown merely by way of non-limiting example in Fig. 2 comprises a platform 1, a bearing 2, an actuator 3, a reference mass 4, a reference mass bearing 5, a first sensor 6 and a second sensor 7. The system further comprises a first control unit 11 for controlling the actuator 3 and a second control unit 15 for controlling the reference mass bearing 5.

The platform 1 that is supported by a platform bearing 2 can be moved by an actuator 3. Although the platform bearing 2 and the actuator 3 might be two separate components, the functions of these two elements can be combined into one element like a Lorentz actuator. The reference mass 4 is supported by a reference mass bearing 5 that is designed in such a way that there is no mechanical contact between the mass and the platform.

The system according to the invention also comprises a first sensor 6 providing a signal that is representative for the absolute distance d1 between the platform 1 and the reference mass 4, and a second sensor 7 providing a signal that is representative of the distance d2 between the reference mass 4 and the floor 8. The second sensor does not necessarily have to meet specific demands. It might be a velocity sensor or an acceleration sensor measuring the relative distance or a sensor that measures the absolute distance. Of course the floor can also be any other construction supporting the platform bearing and the actuator whether or not this construction is fixed to earth.

The reference mass 4 is mounted in a support unit 10 bearing the reference mass 4 without any mechanical contact. The support unit 10 serves as reference mass bearing 5.

In accordance with the present invention, the support unit 10 is placed or mounted on the platform 1. In another embodiment of the system according to the invention, the support unit 10 is fixed to the platform 1. The controller 11 is provided with the output signal of the first sensor 6 and the output signal of the second sensor 7 and the controller 11 itself provides the actuator 3 with an input signal to move the platform 1.

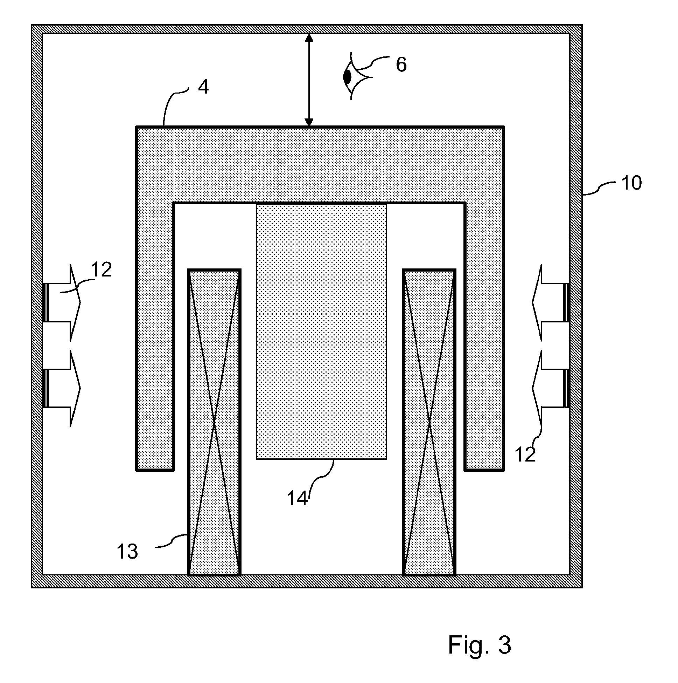

Figure 3 shows a preferred embodiment of a Lorentz type of support unit 10, the reference mass 4 and the sensor 6 with one degree of freedom. The sensor may be an optical interferometer, a capacitor or any other sensing element that can measure the distance between the reference mass 4 and the platform 1 or the housing 11 of the support unit placed on the platform or mounted on it. The sensor, however, should be contactless, to prevent coupling of vibrations to the reference mass 4. The support unit 10 comprises a coil 13 in which a permanent magnet 14 is situated. The permanent magnet 14 is fixed to the reference mass 4. In this particular embodiment a movement in one of the other degrees of freedom is prevented by an air bearing 12. The reference mass may also be supported without making mechanical contacts by other means, such as particular configurations with several magnets or by means of an electrostatic force.

To illustrate the present invention, consider a platform of $m_p$=30 kg, which is suspended by a (passive) bearing with stiffness of $k_p$=50·10$^3$ N/m with a damping ratio of 10% such that the damping will be $d_p$=245 kg/s. Then the transfer function from the base vibrations, represented by $Z_b$, to the platform, represented by $z_p$, is given by

$$z_p = \frac{d_p s + k_p}{m_p s^2 + d_p s + k_p} z_b$$

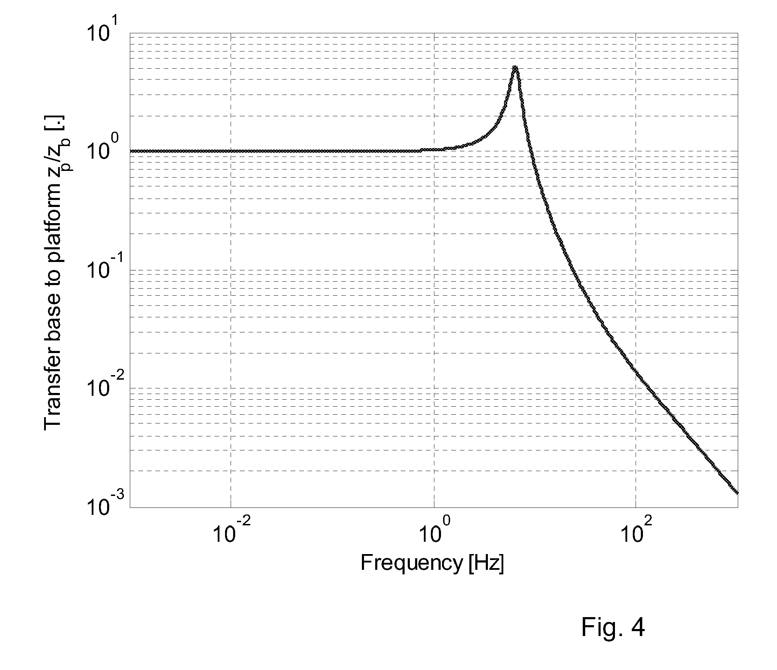

where s the Laplace operator. This transfer function is depicted in Figure 4.

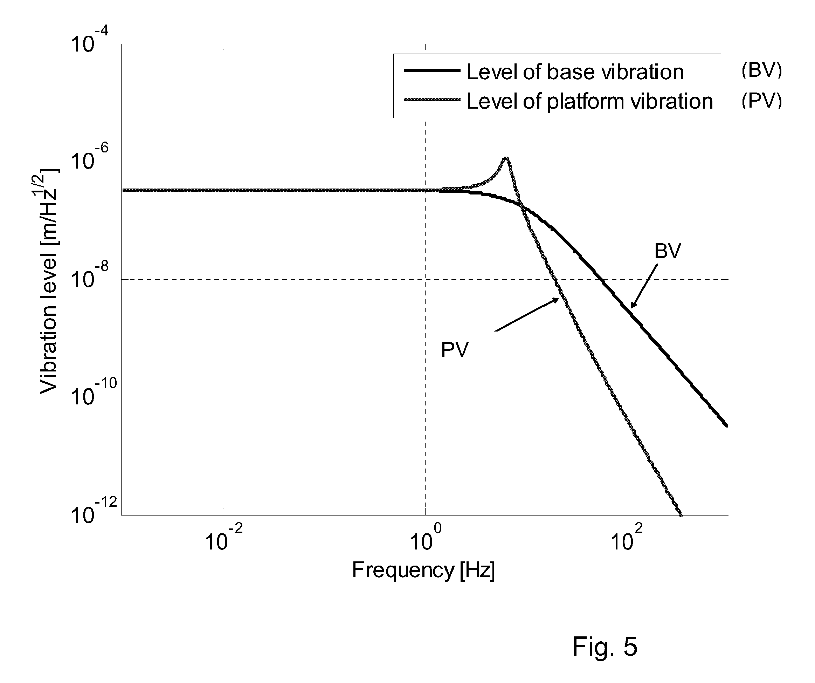

Figure 5 shows the level of vibration of the base, which is assumed to have a root-mean-square (RMS) value of 1 $\mu$m over a bandwidth of 10 Hz. The resulting level of the platform is also depicted in Figure 5. When a voice coil actuator 3 is used to actuate a force between the base and the platform the actuator force $F_{p,a}$ can be approximately described by

$$F_{p,a} = K_{p,o}(1 + \gamma_p(z_p - z_b - z_{p,o})^2)K_i V_p$$

where $V_p$ the voltage output of the controller, $K_i$ the gain of the voltage to current amplifier to drive the current through the coil. $K_{p,o}$ is the nominal motor constant of the voice coil and $\gamma_p$ a parameter that determines the stiffness variation of the voice coil and $z_{p,o}$ the zero-stiffness position. Optionally, the position-dependent gain $K_{p,o} (1 + \gamma_p(z_p - z_b - z_{p,o})^2)$ of the voice coil actuator can be approximated by a more complex structure, such as a higher order polynomial, a rational function, a neural network, a spline approximation or table lookup. The coefficients of the interpolating functions can be determined on the basis of measured data using standard algorithms, such as (nonlinear) least squares or root finding methods. In the example of the invention, a Bei Kimco LA 10-12-027A voice coil has been used with $K_{p,o}$ = 5.8 N/A and $\gamma_p$ = - 4.5 · 10$^3$/m$^2$ and $z_{p,o}$=1.6 mm, which depends on the precise alignment of the displacement sensor (7) which measures the displacement

$$z_{p,m} = z_p - z_b + z_{p,n}$$

where $z_{p,n}$ is the measurement noise (using accurate capacitive sensors, or interferometers, the measurement noise level may be below $1 \cdot 10^{-9}/\sqrt{5000}\mathrm{m}/\mathrm{Hz}^{1/2}$ over a bandwidth of 5000 Hz).

The sensor system is mounted on top of the platform. The inertial reference mass with mass $m_s$=0.160 kg is lifted up using voice coil actuator, which supplies a force

$$F_{s,a} = K_{s,o}(1 + \gamma_s(z_s - z_p - z_{s,o})^2)i_s$$

where $K_{s,o}=K_{p,o}$, $\gamma_s =$ and e.g. $z_{s,o}$=1 mm depending on the alignment of the displacement sensor. The current consists of two terms:

$$i_s = i_{s,o} + K_{s,i}V_s$$

where $i_{s,o}$ a DC term to generate a DC force counteracting the gravity force which can be supplied by a separate stable DC current source. The other term $K_{s,i} V_s$ contains the transfer of the voltage to the current converter, e.g., $K_{s,i}$=0.001A/V, and the control voltage $V_s$ supplied by the controller.

When the gravity forces are counteracted by the platform bearing and the reference mass by the DC current $i_{s,o}$ through the coil of voice coil actuator (3), the position of the platform and the sensor mass are determined by the following coupled differential equations:

$$m_s s^2 z_s = (d_s s + k_s)(z_p - z_s) + K_{s,o}(1 + \gamma_s(z_s - z_p - z_{s,o})^2)K_{s,i}V_s$$
$$m_p s^2 z_p = (d_p s + k_p)(z_b - z_p) - (d_s s + k_s)(z_p - z_s) + F_{p,n} +$$
$$+ K_{p,o}(1 + \gamma_p(z_p - z_b - z_{p,o})^2)K_{p,i}V_p$$

where the term $F_{p,n}$ represents other disturbance forces that act on the platform, i.e. due to moving instruments on the platform as is common in lithography applications. The reference mass is isolated sufficiently from acoustic disturbances and other forces (e.g., by using a vacuum chamber) such that the disturbance forces on the inertial reference mass $m_s$ can be neglected. Because the reference mass is not supported by a passive bearing, we may set $k_s$=0 N/m and $d_s$=0 kg/s.

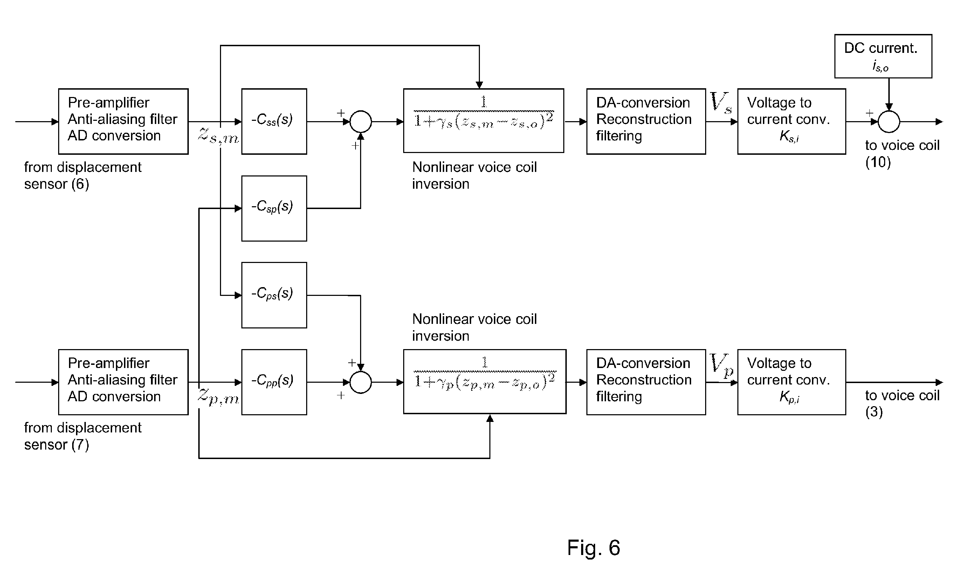

A preferred controller setup is depicted in Figure 6. The inputs to the controller are the displacement sensor (6 in Fig. 2) that measures the relative distance between the reference mass and the platform, $z_{s,m} = z_s - z_p + z_{s,m}$, where $z_{s,n}$ the measurement noise which is of the same level as the measurement noise on the measurement supplied by sensor (7 in Fig. 2), that represents the distance between the platform and the base, $z_{p,m} = z_p - z_b + z_{p,m}$. These relative positions are the inputs of four linear dynamic controllers, that are described below, and also used in the compensation of the voice coils stiffness dependency of the relative positions. When the compensation is perfectly done, the dynamics of the whole system can be described by linear differential equations. Now, the controllers could be designed using optimal $H_2$, LQG, or $H_\infty$ optimal control. However, the disadvantage is that in fact we want to optimize the performance particularly in the band 0.1-10 Hz, whereas these optimization methods optimize over the whole frequency range. In fact one may use particular frequency dependent weighting functions, but these increase the complexity of the controller and it may be rather cumbersome to design the weighting filters. Moreover, these methods are based on the availability of very accurate parametric models of the system.

The present invention does not follow this approach but provides insight in the relation between the controllers and the achieved vibration suppression and compliance behaviour, which result in tuning rules to determine the controller parameters.

The controllers $C_{ss}$ and $C_{pp}$ are adjusting the stiffness and damping characteristics between the platform and the inertial reference mass and between the base and the platform respectively. This can be seen directly from the dynamics of the controlled system by setting the (cross)controllers $C_{sp}$ and $C_{ps}$ to zero, and assuming that the nonlinearity is perfectly compensated, which yields the following transfer from $z_b$ to $z_s$ and $z_p$ in the Laplace domain:

$$\begin{bmatrix} z_s \\ z_p \end{bmatrix} = \left( \left( m_s s^2 + K_{s,o} K_{s,i} C_{s,s} \right) \left( m_p s^2 + d_p s + k_p + K_{p,o} K_{p,i} C_{p,p} \right) \right)^{-1} \times$$

$$\begin{bmatrix} K_{s,o} K_{s,i} C_{s,s} \left( d_p s + k_p + K_{p,o} K_{p,i} C_{p,p} \right) \\ \left( m_s s^2 + K_{s,o} K_{s,i} C_{s,s} \right) \left( d_p s + k_p + K_{p,o} K_{p,i} C_{p,p} \right) \end{bmatrix} z_b$$

From this expression we observe that $C_{s,s}$ determines the resonance frequency and damping of the sensor system relative to the platform and $C_{p,p}$ the resonance frequency and damping of the platform relative to the base. $C_{s,s}$ is designed such that some stiffness is added to prevent the reference mass from drifting. The resonance frequency of the reference mass is set to 0.1 Hz and at this frequency a phase-lead of 30° has been added to increase the damping around this resonance frequency by means of a lead compensator

$$C_{s,s} = \frac{51.7s + 18.76}{s + 1.088}$$

On the other hand $C_{p,p}$ is designed to reduce the stiffness $k_p$ and the damping $d_p$, and thus to lower the resonance frequency of the platform. We select

$$C_{p,p} = -\frac{288.8s + 7.759 \cdot 10^4}{1 \cdot 10^{-6} s^2 + 0.002s + 1}$$

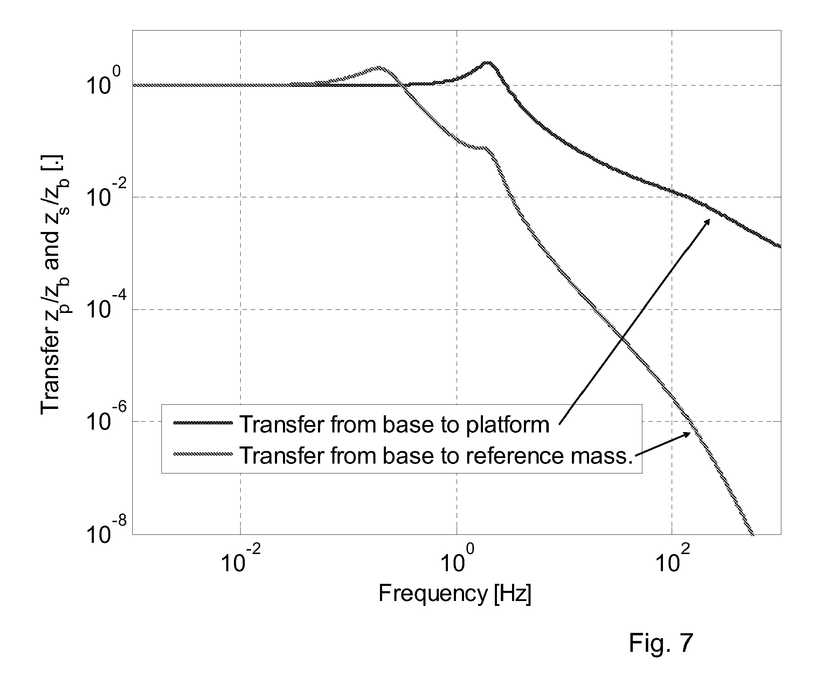

which introduces a negative stiffness and damping together with two poles at 1000 rad/s to obtain sufficient roll-off at high frequencies. In this way the resonance frequency of the base-platform connection is shifted from 6.4 Hz to 2.6 Hz. controller $C_{p,s}$ the basic 'absolute' position feedback; derivation of performance depending on $C_{p,s}$ interpretation of servo controller; Fig. 7: bode-plot for loop-shaping of $C_{p,s}$.

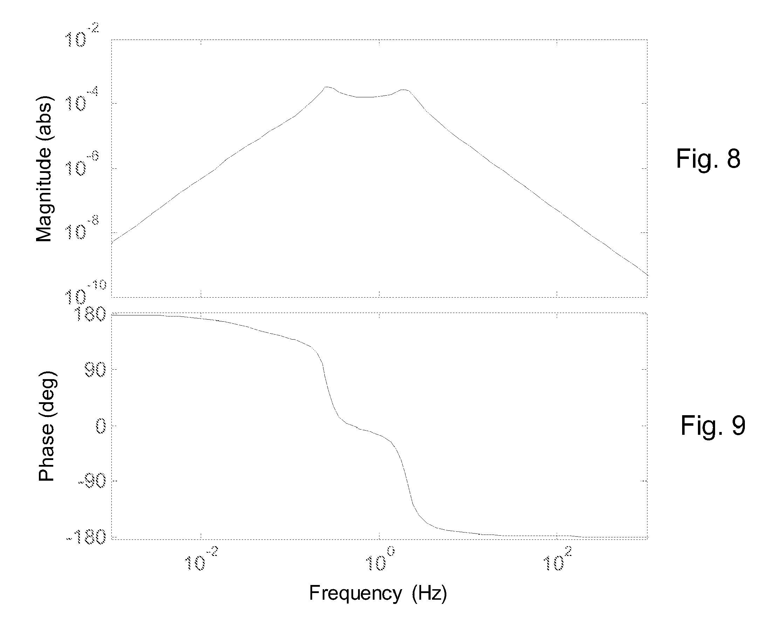

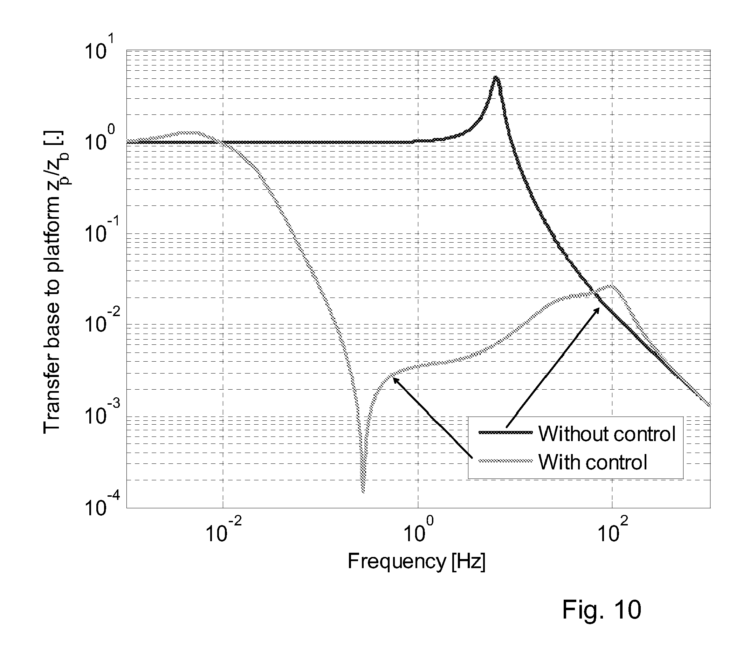

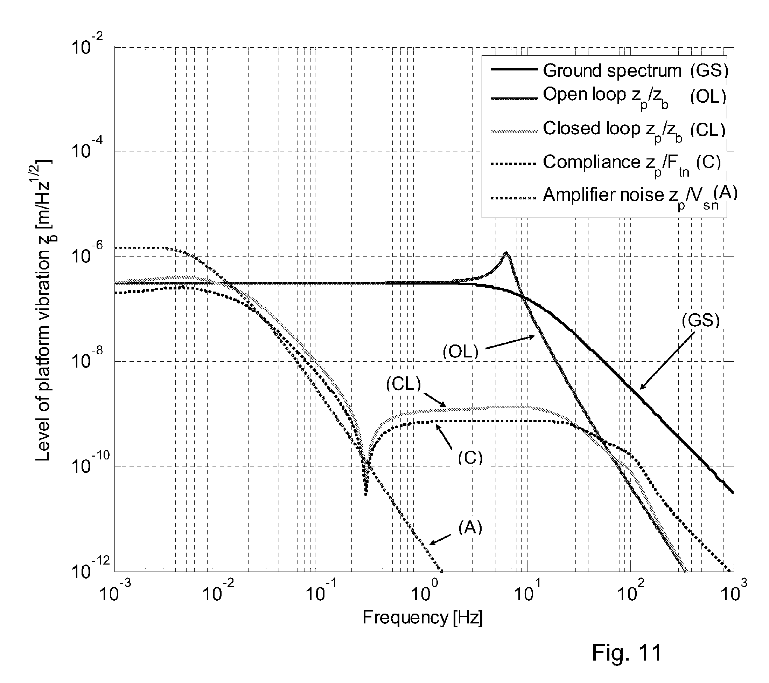

Figs. 9 and 10 show the performance obtained, while Fig. 11 illustrates sensitivity at low frequencies to disturbance forces on the platform as well as noise due to the 1/f characteristic of the amplifier used to control voice coil 3.

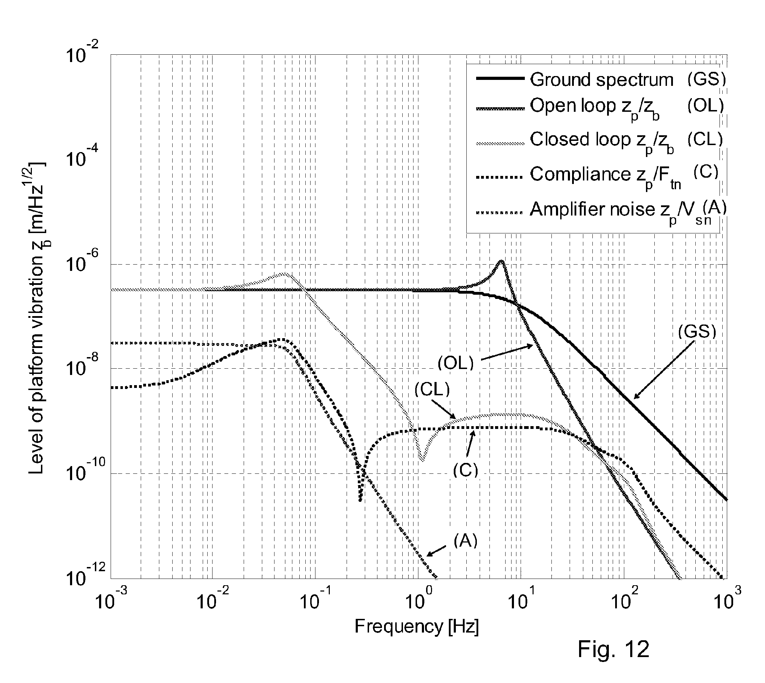

A stiffer connection between the platform and the inertial reference mass will slightly suppress the amplifier noise, but does not suppress the sensitivity to disturbance forces. It is generally better to use voice coil 3 as an inertial shaker to actively suppress these disturbances. This can be achieved by controller $C_{s,p}$ which actuates voice coil 3 using measurements from the sensor 7. Fig. 12 illustrates the suppression achieved at low frequencies, but at the expense of the performance below 1 Hz.

An embodiment has been described above for one degree of freedom but persons skilled in the art can easily incorporate the principles for all six degrees of freedom.

The present invention is based upon the insight that a further improvement of present active vibration isolation systems is possible without increasing the compliance when using an inertial reference mass placed on, or at least attached to, the platform in combination with a control system that comprises both a feedback from the displacement of the platform relative to the inertial reference mass and a feedback from the displacement of the platform relative to the source of the vibration.

It is noted that any terms used in this document should not be construed so as to limit the scope of the present invention. In particular, the words "comprise(s)" and "comprising" are not meant to exclude any elements not specifically stated. Single (circuit) elements may be substituted with multiple (circuit) elements or with their equivalents.

The present invention not only relates to protecting the isolated equipment from vibrations originating from its environment but also to protecting the environment from the vibrations originating from the equipment that is isolated.

It will therefore be understood by those skilled in the art that the present invention is not limited to the embodiments illustrated above and that many modifications and additions may be made without departing from the scope of the invention as defined in the appending claims.

**Claims**

1. An active vibration isolation system comprising a platform (1), an inertial reference mass (4), a support unit (10) for supporting the reference mass (4) without mechanical contact, a first sensor (6) for supplying a signal that is representative of the distance (d1) between the reference mass (4) and the platform (1), an actuator (3) for displacing the platform (1) with respect to a bearing body (8), a second sensor (7) for supplying a signal that is representative of the distance (d2) between the platform (1) and the bearing body (8), and a control unit (11) for controlling the actuator (3), **characterised in that** the support unit (10) is supported by the platform (1).

2. The system according to claim 1, in which the support unit (10) comprises a Lorentz type of geometry supporting the reference mass (4).

3. The system according to claim 1, in which the support unit (10) comprises electromagnetic, electro-static or magneto-static mains for supporting the reference mass (4).

4. The system according to any of the preceding claims, in which the distance (d1) between reference mass and the platform is measured by optical, electrical, or electro-magnetic means.

5. The system according to any of the preceding claims, in which the actuator (3) comprises a Lorentz type of geometry.

6. The system according to any of the preceding claims, in which the control unit (11) receives an absolute feed-back signal from the first sensor (6).

7. The system according to any of the preceding claims, in which the support unit (10) is controlled by a further control unit (15) in dependence on the first sensor (6) and the second sensor (7).

Fig. 1

Fig. 2

Fig. 3

Fig. 4

Fig. 5

EP 2 075 484 A1

Fig. 6

Fig. 7

Fig. 8

Fig. 9

Fig. 10

Fig. 11

Fig. 12

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,A | WO 2005/024266 A (KONINKL PHILIPS ELECTRONICS NV [NL]; VERVOORDELDONK MICHAEL J [NL]; RU) 17 March 2005 (2005-03-17) * the whole document * | 1 | INV. F16F15/02 F16F15/03 |
| A | US 2005/018160 A1 (DAMS JOHANNES ADRIANUS ANTONIU [NL] ET AL) 27 January 2005 (2005-01-27) * paragraph [0056] - paragraph [0075] * | 1 | |
| A | WO 2005/073592 A (KONINKL PHILIPS ELECTRONICS NV [NL]; WARMERDAM THOMAS P H [NL]; VERVOO) 11 August 2005 (2005-08-11) * the whole document * | | |
| A | US 2004/060792 A1 (WARMERDAM THOMAS P H [NL]) 1 April 2004 (2004-04-01) * the whole document * | 1 | |
| D,A | & WO 2004/029475 A (KONINKL PHILIPS ELECTRONICS NV [NL]; PHILIPS CORP [US]) 8 April 2004 (2004-04-08) | | TECHNICAL FIELDS SEARCHED (IPC) |
| A | DE 296 12 349 U1 (HEILAND PETER [DE]) 20 November 1997 (1997-11-20) | | F16F G03F G05D |
| A | NELSON P G: "AN ACTIVE VIBRATION ISOLATION SYSTEM FOR INERTIAL REFERENCE AND PRECISION MEASUREMENT" REVIEW OF SCIENTIFIC INSTRUMENTS, AIP, MELVILLE, NY, US, vol. 62, no. 9, 1 September 1991 (1991-09-01), pages 2069-2075, XP000262841 ISSN: 0034-6748 | | |

The present search report has been drawn up for all claims

| Place of search | Date of completion of the search | Examiner |
|---|---|---|
| The Hague | 27 June 2008 | Pemberton, Paul |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 2 075 484 A1

## ANNEX TO THE EUROPEAN SEARCH REPORT
## ON EUROPEAN PATENT APPLICATION NO.

EP 07 12 4174

This annex lists the patent family members relating to the patent documents cited in the above-mentioned European search report.
The members are as contained in the European Patent Office EDP file on
The European Patent Office is in no way liable for these particulars which are merely given for the purpose of information.

27-06-2008

| Patent document cited in search report | | Publication date | Patent family member(s) | | | Publication date |
|---|---|---|---|---|---|---|
| WO 2005024266 | A | 17-03-2005 | JP | 2007504415 | T | 01-03-2007 |
| | | | US | 2007035074 | A1 | 15-02-2007 |
| US 2005018160 | A1 | 27-01-2005 | JP | 4083708 | B2 | 30-04-2008 |
| | | | JP | 2005294790 | A | 20-10-2005 |
| WO 2005073592 | A | 11-08-2005 | CN | 1914436 | A | 14-02-2007 |
| | | | JP | 2007522393 | T | 09-08-2007 |
| US 2004060792 | A1 | 01-04-2004 | AU | 2003263499 | A1 | 19-04-2004 |
| | | | CN | 1685168 | A | 19-10-2005 |
| | | | EP | 1552184 | A1 | 13-07-2005 |
| | | | WO | 2004029475 | A1 | 08-04-2004 |
| | | | JP | 2006500535 | T | 05-01-2006 |
| | | | KR | 20050057565 | A | 16-06-2005 |
| WO 2004029475 | A | 08-04-2004 | AU | 2003263499 | A1 | 19-04-2004 |
| | | | CN | 1685168 | A | 19-10-2005 |
| | | | EP | 1552184 | A1 | 13-07-2005 |
| | | | JP | 2006500535 | T | 05-01-2006 |
| | | | KR | 20050057565 | A | 16-06-2005 |
| | | | US | 2004060792 | A1 | 01-04-2004 |
| DE 29612349 | U1 | 20-11-1997 | NONE | | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005024266 A1

- WO 2004029475 A

**Non-patent literature cited in the description**

- **P.R. Saulson.** Vibration isolation for broadband gravitational wave antennas. *Rev. Sci. Instrum.,* August 1984, vol. 55 (8), 1315-1320

- **P.G. Nelson.** An active vibration isolation system for inertial reference and precision measurement. *Rev. Sci. Instrum.,* September 1991, vol. 62 (9), 2069-2075